# EUROPEAN PATENT APPLICATION

(11) **EP 0 590 652 A2**
(43) Date of publication of application: **06.04.1994**
(21) Application number: 93115754.9
(22) Date of filing: 29.09.1993
(51) Int. Cl.: H01L 21/82, H01L 23/48, H01L 21/24

(54) **Method of forming contact between diffused layer and wiring conductor semiconductor device**

(30) Priority: 29.09.1992 JP 259196/92
(71) Applicant: NEC CORPORATION, Tokyo (JP)
(72) Inventor: Watanabe, Takeshi, Minato-ku, Tokyo (JP)
(74) Representative: Glawe, Delfs, Moll & Partner

(57) **Abstract**

Phosphorus is ion-implanted over a whole surface so as to prevent a leakage current which would occur when a margin between the N⁺ diffused layer (5) and the contact holes is reduced. By using only one lithography process, boron is ion-implanted into the P⁺ diffused layer (6) with the dose larger than the dose of the phosphorus ion-implantation, so that even if a margin between the P⁺ diffused layer (6) and the contact holes is reduced, a leakage current will never flow, and a small contact resistance is realized. A contact between a wiring conductor having a Ti-N layer and N⁺ and P⁺ diffused layers can be formed with a reduced number of steps and with a reduced ion implantation dose.

## Description

### Background of the Invention

### Field of the invention

The present invention relates to a method of manufacturing a semiconductor device, and more particularly, to a process of forming a contact between a diffused layer and an electrode/wiring conductor.

### Description of related art

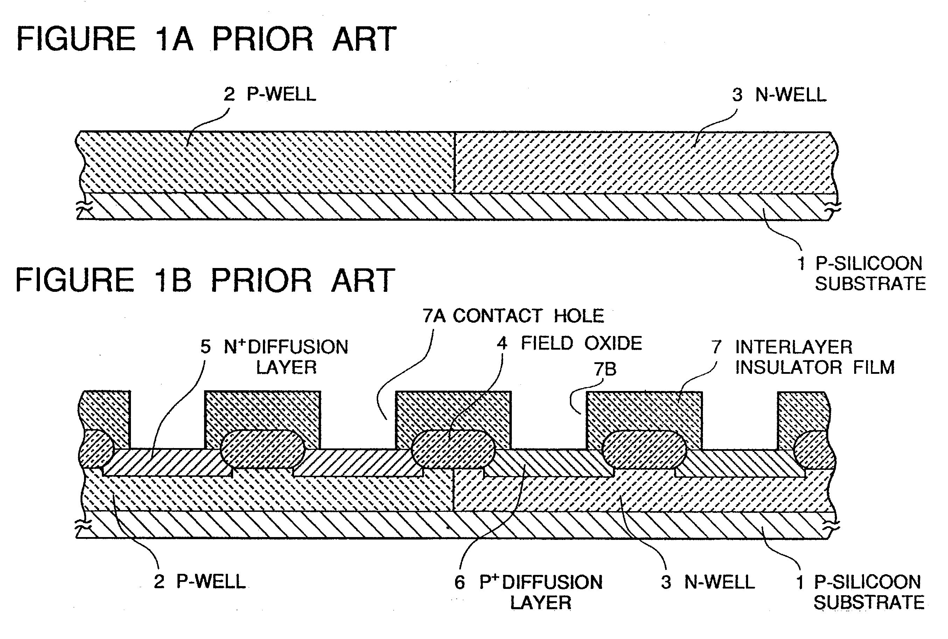

One conventional method of manufacturing a semiconductor device will be described with reference to Figures 1A to 1E.

First, boron is ion-implanted into one principal surface of a P-type silicon substrate 1 as shown in Figure 1A, with a dose on the order of 1.0 × 10¹³cm⁻² under an acceleration voltage of 150KeV. Then, phosphorus is ion-implanted into only an N-well formation area of the substrate by use of a lithographic process with a dose on the order of 2.0 × 10¹³cm⁻² under an acceleration voltage of 150KeV. Furthermore, a heat treatment is performed so that the phosphorus and the boron are diffused so as to form a P-well 2 and an N-well 3, respectively, as shown in Figure 1A.

After completion of the heat treatment, a field oxide film 4 as shown in Figure 1B is formed in the principal surface of the P-type substrate 1 by using a selective oxidation process, so that a plurality of device formation areas are partitioned, and necessary steps are performed in order to form a not-shown gate oxide film, a gate electrode and others. Thereafter, arsenic ions are selectively implanted into a surface region of the P-well 2 by use of a lithographic process with a dose on the order of 3.0 × 10¹⁵cm⁻² under an acceleration voltage of 50KeV, and boron difluoride ions are selectively implanted into a surface region of the N-well 3 by use of a lithographic process with a dose on the order of 3.0 × 10¹³cm⁻² under an acceleration voltage of 70KeV. In addition, a heat treatment is performed at a temperature of about 90°C, so that N⁺ diffused layers 5 and P⁺ diffused layers 6 are formed, as shown in Figure 1B.

Then, an interlayer insulator film 7 of about 300nm in thickness is deposited on a whole surface by a CVD process, and contact holes 7A and 7B are formed in the interlayer insulator film at positions above the N⁺ diffused layers 5 and the P⁺ diffused layers 6.

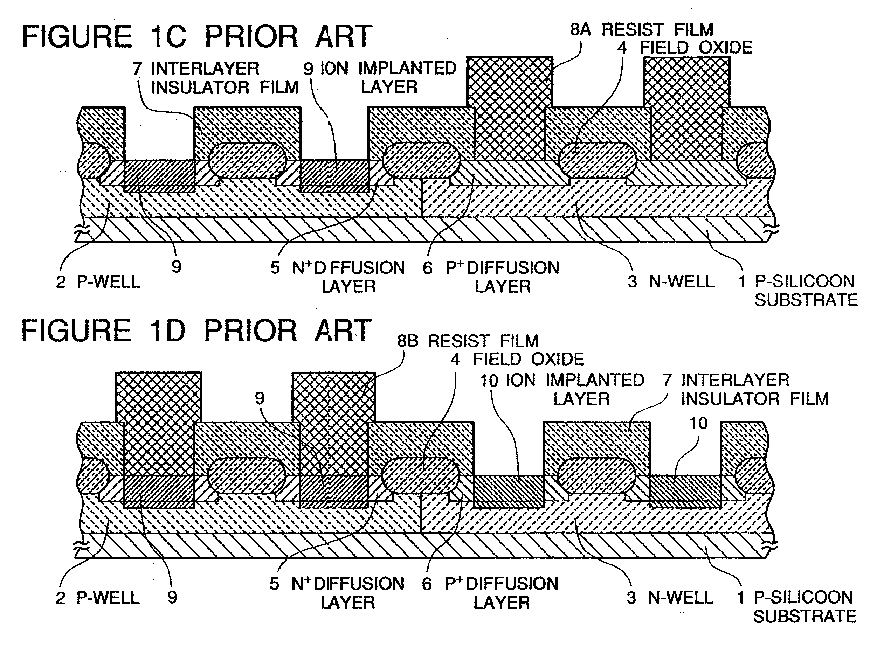

After formation of the contact holes, in order to prevent a leakage current which would occur when a margin between the N⁺ diffused layer 5 and the contact holes is reduced, phosphorus ions are implanted into only the N⁺ diffused layers 5 with a dose on the order of 5.0 × 10¹⁵cm⁻² under an acceleration voltage of 70KeV, by leaving a resist film 8A in the contact holes 7B above the P⁺ diffused layers 6 by means of a lithographic process, so that ion implanted layers 9 are formed, as shown in Figure 1C.

Thereafter, in order to prevent a leakage current which would occur when a margin between the P⁺ diffused layer 6 and the contact holes is reduced, and in order to reduce the contact resistance, boron ions are implanted into only the P⁺ diffused layers 6 with a dose on the order of 5.0 × 10¹⁵cm⁻² under an acceleration voltage of 30KeV, by leaving a resist film 8B in the contact holes 7A on the N⁺ diffused layers 5 by means of a lithographic process, so that ion implanted layers 10 are formed, as shown in Figure 1D.

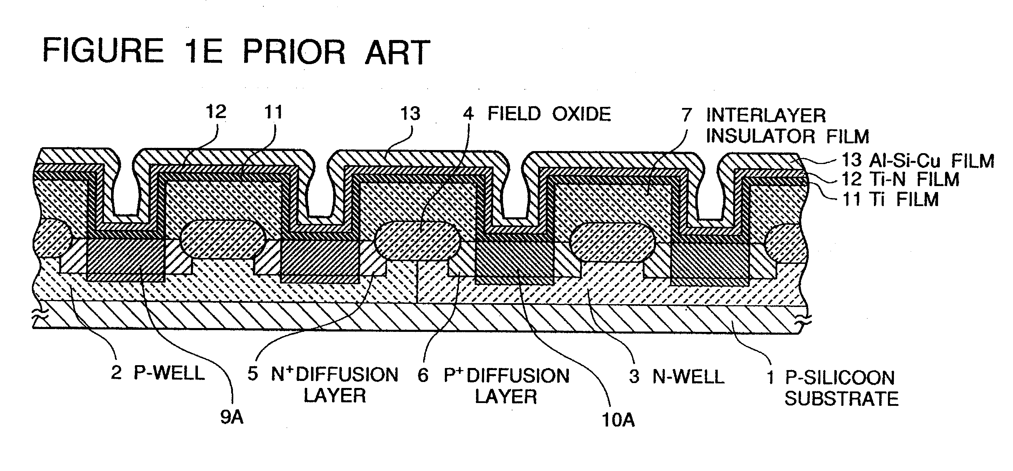

Then, as shown in Figure 1E, a titanium film 11 (60nm in thickness) and a titanium nitride layer 12 (100nm in thickness) are deposited by a sputtering, and a heat treatment is performed. With this process, the ion implanted layers 9 and 10 become N⁺ contact layers 9A and P⁺ contact layers 10A, respectively. After the heat treatment, an Al-Si-Cu film 13 is deposited by a sputtering, so as to have a thickness of 600nm, and then, the deposited layers are etched by use of a lithographic process, so as to form all electrode/wiring conductor.

In this conventional manufacturing process, since the phosphorus ions and the boron ions are implanted into the N⁺ diffused layer and the P⁺ diffused layer, respectively, it is disadvantageous in that the process becomes long. In addition, since the contact resistance between the Al-Si-Cu film/Ti-N film/Ti film stacked structure and the P⁺ diffused layer is greatly dependent upon an impurity concentration of the surface of the P⁺ diffused layer, in order to lower the contact resistance it is necessary to ion-implant a large amount of boron, which will cause a charge-up, and which also increase the time of the ion implantation process. These are also disadvantageous.

### Summary of the Invention

Accordingly, it is an object of the present invention to provide a process of forming a contact between a diffused layer and an electrode/wiring conductor, which has overcome the above mentioned defect of the conventional one.

Another object of the present invention is to provide a process of forming a contact between a diffused layer and an electrode/wiring conductor, with a reduced impurity dose and with a reduced contact resistance.

The above and other objects of the present invention are achieved in accordance with the present invention by a process of forming a contact between a diffused layer and an electrode/wiring conductor in a semiconductor device, which comprises the steps of selectively forming a diffused layer of a first conduction type and a diffused layer of a second conduction type opposite to the first conduction type in a surface of a semiconductor substrate, depositing an interlayer insulator film on the surface of the semiconductor substrate, forming contact holes through the interlayer insulator film so that the first conduction type diffused layer is exposed through a first contact hole and the second conduction type diffused layer is exposed through a second contact hole, introducing impurity of the second conduction type through the first and second contact holes into the first conduction type diffused layer and the second conduction type diffused layer, introducing impurity of the first conduction type through the first contact hole into only the first conduction type diffused layer, performing a heat treatment, and forming a wiring layer having a barrier metal film in contact with each of the first conduction type diffused layer and the second conduction type diffused layer through the first arid second contact holes.

In a preferred embodiment, the process in accordance with the present invention of forming the contact between a diffused layer and an electrode/wiring conductor in a semiconductor device, comprises the steps of selectively forming a P-type diffused layer and an N-type diffused layer in a surface of a semiconductor substrate, depositing an interlayer insulator film on the surface of the semiconductor substrate, forming contact holes through the interlayer insulator film so that the P-type diffused layer is exposed through a first contact hole and the N-type diffused layer is exposed through a second contact hole, introducing an N-type impurity through the first and second contact holes into the P-type diffused layer and the N-type diffused layer, introducing a P-type impurity through the first contact hole into only the P-type diffused layer, performing a heat treatment, and forming a wiring layer in contact with each of the P-type diffused layer and the N-type diffused layer through the first and second contact holes by depositing a barrier metal layer on the P-type diffused layer and the N-type diffused layer within the first and second contact holes, filling a metal into the first and second contact holes so as to form a substantially planar upper surface, depositing an upper metal layer on the metal filled in the first and second contact holes, and patterning the deposited metal layers.

More specifically, he semiconductor substrate is a silicon substrate. The P-type diffused layer is formed by selectively doping boron into a surface of a N-type well formed in the surface of the silicon substrate, and the N-type diffused layer is formed by selectively doping arsenic into a surface of an N-type well formed in the surface of the silicon substrate. In addition, the N-type impurity is phosphorus, and the P-type impurity is boron.

Furthermore, when the phosphorus is ion-implanted with a dose of 2.0 × 10¹⁴cm⁻², the boron is preferably ion-implanted with a dose in the range of 1.5 × 10¹⁵cm⁻² to 2.0 × 10¹⁵cm⁻² inclusive. In addition, the barrier metal layer is formed by depositing a titanium film and a titanium nitride film in the named order. The filling metal is formed of tungsten, and the upper metal layer is formed of an Al-Cu film.

The above and other objects, features and advantages of the present invention will be apparent from the following description of preferred embodiments of the invention with reference to the accompanying drawings.

### Brief Description of the Drawings

Figures 1A to 1E are diagrammatic views illustrating a conventional example of the process of forming a contact between a diffused layer and an electrode/wiring conductor in a semiconductor device;
Figures 2A to 2C are diagrammatic views illustrating one embodiment of the process in accordance with the present invention for forming a contact between a diffused layer and an electrode/wiring conductor in a semiconductor device;
Figure 3 is a graph showing the relation between the phosphorus ion dose and the contact resistance between the Al-Si-Cu film/Ti-N film/Ti film stacked structure and the N⁺ contact layer in one embodiment of the present invention; and
Figure 4 is a graph showing the relation between the ion implantation dose and the contact resistance between the Al-Si-Cu film/Ti-N film/Ti film stacked structure and the P⁺ contact layer in one embodiment of the present invention

### Description of the Preferred embodiments

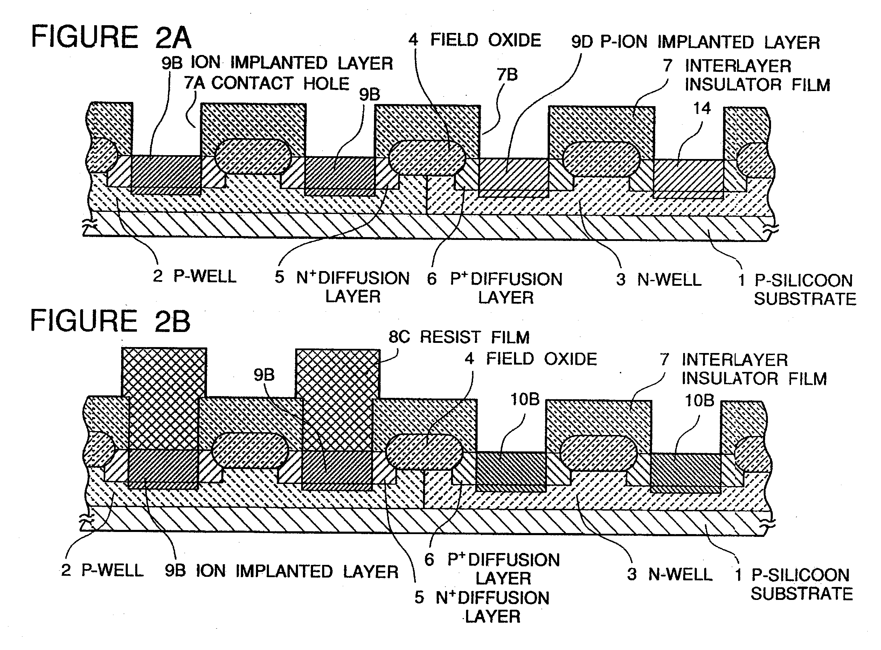

Now, one embodiment of the process in accordance with the present invention for forming a contact between a diffused layer and an electrode/wiring conductor in a semiconductor device will be described. Similarly to the conventional example explained with reference to Figures 1A to 1E, an N⁺ diffused layer 5 and a P⁺ diffused layer 6 are formed, and an interlayer insulating layer 7 is deposited. Thereafter, contact holes 7A and 7B are formed, as shown in Figure 2A.

After formation of the contact holes, in order to prevent a leakage current which would occur when a margin between the N⁺ diffused layer 5 and the contact holes is reduced, phosphorus ions are implanted through, the contact holes 7A and 7B with a dose on the order of 2.0 × 10¹⁴cm⁻² under an acceleration voltage of 70KeV, so as to form ion implanted layers 9B and phosphorus ion implanted layers 9D, as shown in Figure 2A.

Thereafter, in order to prevent a leakage current which would occur when a margin between the P⁺ diffused layer 6 and the contact holes is reduced, and in order to reduce the contact resistance, a resist film 8C is deposited in the contact holes 7A above the N⁺ diffused layer 5, as shown in Figure 2B, and then, boron ions are implanted into only the P⁺ diffused layer 6 with a dose on the order of 2.0 × 10¹⁵cm⁻² under an acceleration voltage of 30KeV, so as to form ion implanted layers 10B.

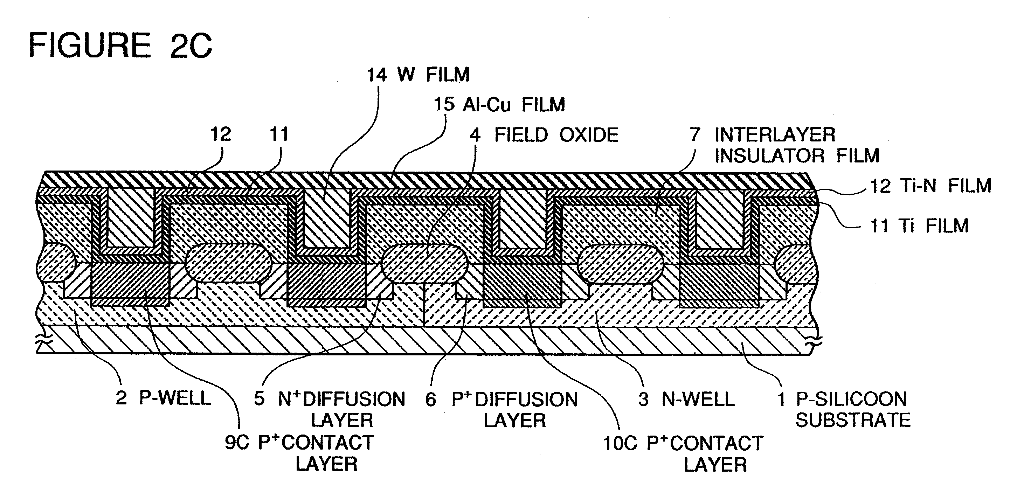

Then, similarly to the conventional example, a titanium film of 60nm and a titanium nitride film of 100nm are deposited by a sputtering, and a heat treatment is performed. With this process, as shown in Figure 2C, the ion implanted layers 9B are brought into N⁺ contact layers 9C, and the ion implanted layers 10B are brought into P⁺ contact layers 10C, as shown in Figure 2C.

Thereafter, a tungsten film can be deposited with a blanket tungsten CVD process, and an etching-back is performed so that the contact holes are filled with the tungsten film 14. Thereafter, an Al-Cu film 15 of about 600nm is deposited as shown in Figure 2C, and then, a patterning is performed. With this process, it is possible to form a wiring conductor having an excellent coverage even in fine contact holes.

In the prior art, in order to reduce the contact resistance, and in order to prevent the leakage current which would occur when a contact margin is reduced, phosphorus was ion-implanted into only the N⁺ diffused layer and boron was ion-implanted into only the P⁺ diffused layer.

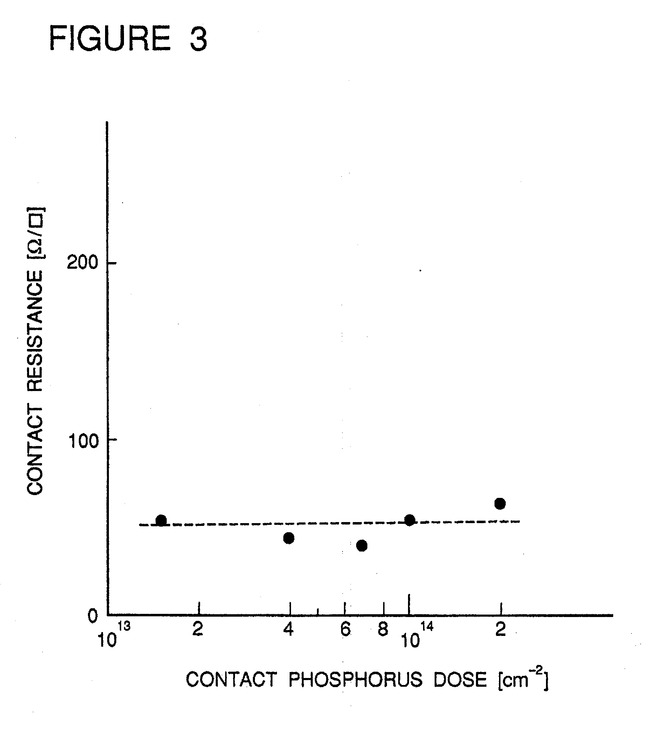

In this embodiment, only phosphorus is ion-implanted into the N⁺ diffused layer, similarly to the prior art. In the case of the N⁺ contact layer, the contact resistance is originally small, and therefore, it is sufficient if the dose of the phosphorus ion-implantation is at a level which can prevent the leakage current which would occur when a contact margin is reduced. Figure 3 shows the measurement result of the contact resistance of the Al-Si-Cu film/Ti-N film/Ti film - N⁺ contact layer in the case of a contact size of 0.55µm□. When the dose of the phosphorus was 2.0 × 10¹⁴cm⁻², the contact resistance is about 60Ω/□, which is comparable to the conventional example.

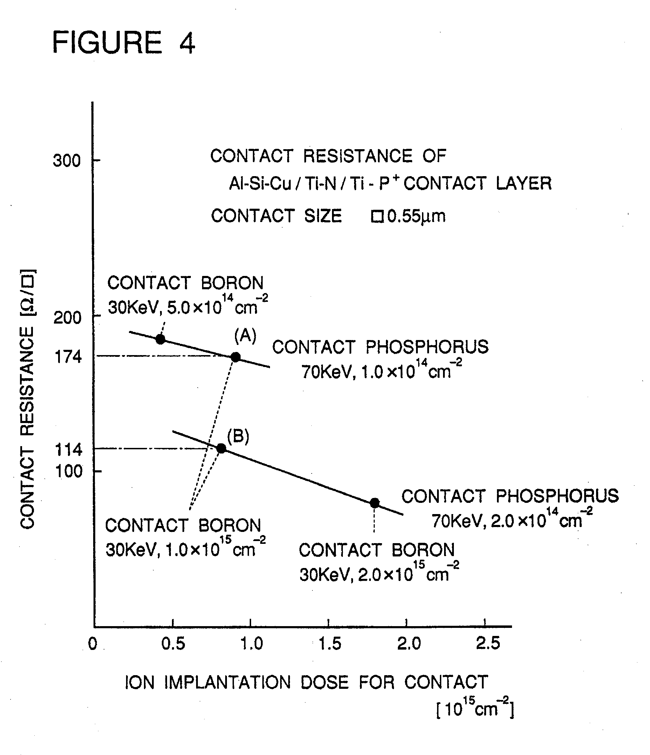

By ion-implanting the phosphorus over the whole surface, the P⁺ diffused layer contains the phosphorus of pentavalence and the boron of trivalence. Therefore, it is expected that if the dose of phosphorus is increased, the contact resistance of the Al-Si-Cu film/Ti-N film/Ti film - N⁺ contact layer would be increased. The result of the actual measurement is shown in Figure 4. The result was in contrary to the expectation. Namely, this is construed as follows: The surface of the P⁺ diffused layer is rendered amorphous by the first phosphorus ion implantation. Thereafter, when the boron is ion-implanted, since the surface has become amorphous, a channeling of the boron ion is suppressed. Accordingly, since the boron concentration of the surface becomes high, the contact resistance has lowered.

In the case of the boron dose of 1.0 × 10¹⁵cm⁻², the contact resistance between the Ai-Si-Cu film/Ti-N film/Ti film stacked structure and the P⁺ contact layer in the phosphorus doses of 1.0 × 10¹⁴cm⁻² (A) and 2.0 × 10¹⁴cm⁻² (B) were about 170Ω/□ and about 110Ω/□, respectively. Accordingly, in order to obtain the contact resistance comparable to that of the conventional example, namely, the contact resistance on the order of 100Ω/□, it will be noted from Figure 4 that in the case of the phosphorus dose of 2.0 × 10¹⁴cm⁻², it is sufficient if the boron dose is on the order of 1.5 × 10¹⁵cm⁻² to 2.0 × 10¹⁵cm⁻². Therefore, the necessary boron dose becomes less than a half of the dose which was required in the conventional example, and accordingly, it is possible to prevent deterioration of the gate oxide caused by the charge-up. In addition, in the shown embodiment, it was confirmed that it is possible to prevent the leakage current although the margin between the diffused layer and the contact hole is reduced to 0µm.

As mentioned above, the present invention can reduce the number of steps, since the formation of the resist film only in the contact holes on the P⁺ diffused layer, which was performed after the phosphorus is ion-implanted into both the N⁺ diffused layer and the P⁺ diffused layer, become unnecessary. In addition, the contact resistance can be lowered with a reduced implanted amount of the contact boron, and therefore, it is possible to prevent the charge-up in the ion implantation step and to shorten the process time.

The invention has thus been shown and described with reference to the specific embodiments. However, it should be noted that the present invention is in no way limited to the details of the illustrated structures but changes and modifications may be made within the scope of the appended claims.

## Claims

1. A process of forming a contact between a diffused layer and an electrode/wiring conductor in a semiconductor device, comprising the steps of selectively forming a P-type diffused layer and an N-type diffused layer in a surface of a semiconductor substrate, depositing an interlayer insulator film on said surface of said semiconductor substrate, forming contact holes through said interlayer insulator film so that said P-type diffused layer is exposed through a first contact hole and said N-type diffused layer is exposed through a second contact hole, introducing an N-type impurity through said first and second contact holes into said P-type diffused layer and said N-type diffused layer, introducing a P-type impurity through said first contact hole into only said P-type diffused layer, performing a heat treatment, and forming a wiring layer having a barrier metal film in contact with each of said P-type diffused layer and said N-type diffused layer through said first and second contact holes.

2. A process claimed in Claim 1 wherein said semiconductor substrate is a silicon substrate, and said P-type diffused layer is formed in a surface of an N-type well formed in the surface of said silicon substrate, and said N-type diffused layer is formed in a surface of a P-type well formed in the surface of said silicon substrate, and wherein said N-type impurity is phosphorus, said P-type impurity is boron, and said barrier metal film is formed of a double layer composed of a titanium film and a titanium nitride film.

3. A process claimed in Claim 2 wherein said phosphorus is ion-implanted through said first and second contact holes into said P-type diffused layer and said N-type diffused layer, and said boron is ion-implanted through said first contact hole into only said P-type diffused layer.

4. A process claimed in Claim 3 wherein said phosphorus is ion-implanted with a dose of 2.0 × 10¹⁴cm⁻² and said boron is ion-implanted with a dose in the range of 1.5 × 10¹⁵cm⁻² to 2.0 × 10¹⁵cm⁻² inclusive.

5. A process of forming a contact between a diffused layer and an electrode/wiring conductor in a semiconductor device, comprising the steps of selectively forming a diffused layer of a first conduction type and a diffused layer of a second conduction type opposite to said first conduction type in a surface of a semiconductor substrate, depositing an interlayer insulator film on said surface of said semiconductor substrate, forming contact holes through said interlayer insulator film so that said first conduction type diffused layer is exposed through a first contact hole and said second conduction type diffused layer is exposed through a second contact hole, introducing impurity of said second conduction type through said first and second contact holes into said first conduction type diffused layer and said second conduction type diffused layer, introducing, impurity of said first conduction type through said first contact hole into only said first conduction type diffused layer, performing a heat treatment, and forming a wiring layer having a barrier metal film in contact with each of said first conduction type diffused layer and said second conduction type diffused layer through said first and second contact holes.

6. A process of forming a contact between a diffused layer and an electrode/wiring conductor in a semiconductor device, comprising the steps of selectively forming a P-type diffused layer and an N-type diffused layer in a surface of a semiconductor substrate, depositing an interlayer insulator film on said surface of said semiconductor substrate, forming contact holes through said interlayer insulator film so that said P-type diffused layer is exposed through a first contact hole and said N-type diffused layer is exposed through a second contact hole, introducing an N-type impurity through said first and second contact holes into said P-type diffused layer and said N-type diffused layer, introducing a P-type impurity through said first contact hole into only said P-type diffused layer, performing a heat treatment, and forming a wiring layer in contact with each of said P-type diffused layer and said N-type diffused layer through said first and second contact holes by depositing a barrier metal layer on said P-type diffused layer and said N-type diffused layer within said first and second contact holes, filling a metal into said first and second contact holes so as to form a substantially planar upper surface, depositing an upper metal layer on said metal filled in said first and second contact holes, and patterning said deposited metal layers.

7. A process claimed in Claim, 6 wherein said semiconductor substrate is a silicon substrate, and said P-type diffused layer is formed by selectively doping boron into a surface of a N-type well formed in the surface of said silicon substrate, and said N-type diffused layer is formed by selectively doping arsenic into a surface of an N-type well formed in the surface of said silicon substrate, and wherein said N-type impurity is phosphorus, and said P-type impurity is boron.

8. A process claimed in Claim 7 wherein said phosphorus is ion-implanted with a dose of 2.0 × 10¹⁴cm⁻² and said boron is ion-implanted with a dose in the range of 1.5 × 10¹⁵cm⁻² to 2.0 × 10¹⁵cm⁻² inclusive.

9. A process claimed in Claim 7 wherein said barrier metal layer is formed by depositing a titanium film and a titanium nitride film in the named order, and wherein said filling metal is formed of tungsten, and said upper metal layer is formed of an Al-Cu film.

10. A process claimed in Claim 9 wherein said phosphorus is ion-implanted with a dose of 2.0 × 10¹⁴cm⁻² and said boron is ion-implanted with a dose in the range of 1.5 × 10¹⁵cm⁻² to 2.0 × 10¹⁵cm⁻² inclusive.
